# EUROPEAN PATENT APPLICATION

(11) **EP 4 806 940 A1**
(43) Date of publication of application: **16.09.2026**
(21) Application number: 24888534.5
(22) Date of filing: 23.10.2024
(51) Int. Cl.: C08G 69/26, G03F 7/004, G03F 7/038

(54) **POLYHYDROXYAMIDE COMPOUND, NEGATIVE PHOTOSENSITIVE RESIN COMPOSITION, DRY FILM, CURED PRODUCT, AND ELECTRONIC COMPONENT**

(30) Priority: 07.11.2023 JP 2023190396
(71) Applicant: TAIYO HOLDINGS CO., LTD., Saitama 355-0222 (JP)
(72) Inventor: SHIBASAKI, Kaho, Hiki-gun, Saitama 355-0222 (JP); YUKIMORI, Daiki, Hiki-gun, Saitama 355-0222 (JP); INOUE, Go, Hiki-gun, Saitama 355-0222 (JP); OKUDA, Ayano, Hiki-gun, Saitama 355-0222 (JP); SUGITA, Kenyu, Hiki-gun, Saitama 355-0222 (JP); ISHIKAWA, Nobuhiro, Hiki-gun, Saitama 355-0222 (JP)
(74) Representative: Hoffmann Eitle
(86) International application number: PCT/JP2024/037734
(87) International publication number: WO 2025/100236

(57) **Abstract**

Provided is a polyhydroxyamide compound capable of providing a new negative photosensitive resin composition free of a resin component that may be subject to PFAS regulations. Provided is a polyhydroxyamide compound containing a structural unit represented by the formula (1) and a structural unit represented by the formula (2): 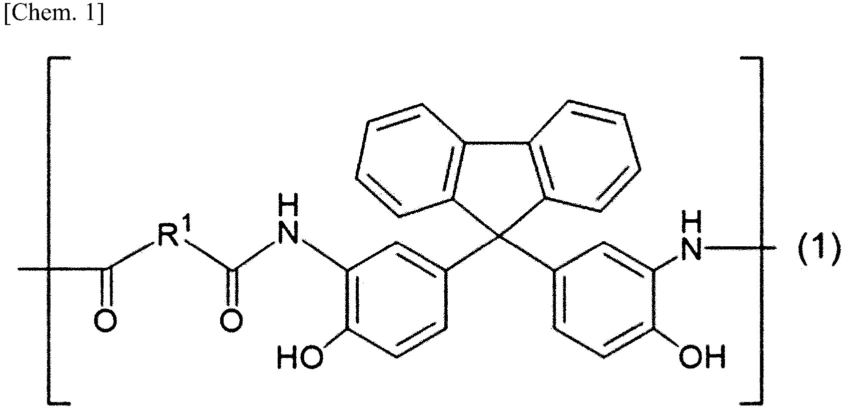 wherein R¹ is a divalent organic group; and 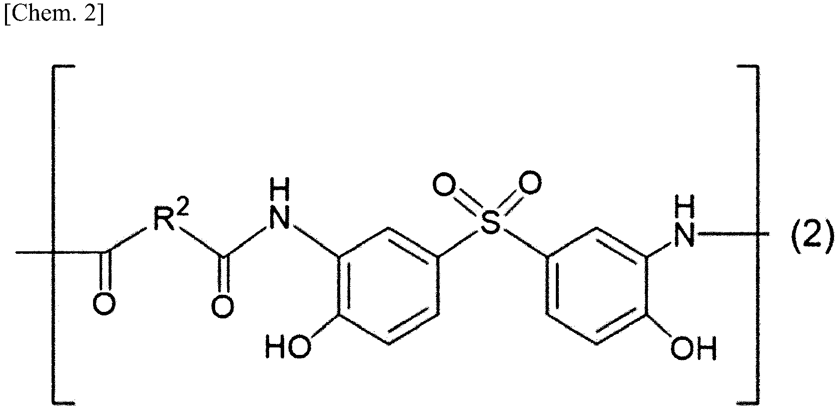 wherein R² is a divalent organic group.

## Description

### Technical Field

The present invention relates to a polyhydroxyamide compound, a negative photosensitive resin composition, a dry film, a cured product, and an electronic component.

### Background Art

Photosensitive resin compositions containing a polyimide precursor exhibit excellent properties such as insulating properties, heat resistance, and mechanical strength, and are therefore widely used in an insulating film in various fields such as semiconductors and electronic components.

Heretofore, high integration of semiconductor elements has been required along with improvement in performance and downsizing of electronic components and electric equipment. In order to meet this requirement, techniques for performance improvement and downsizing have been developed in the field of semiconductor element packages such as wafer-level packages. An insulating film used in a redistribution layer is required to have excellent resolution for miniaturization in pattern formation.

Patent Literature 1 discloses a photosensitive resin composition containing a polybenzoxazole precursor, a compound that generates an acid by irradiation with an actinic ray in a specific wavelength region, a compound that can be crosslinked or polymerized, and a compound that generates an acid by heat. According to the disclosure of Patent Literature 1, a negative photosensitive resin composition that exhibits good sensitivity and resolution and has chemical resistance, heat resistance, and mechanical properties is provided.

### Citation List

### Patent Literature

Patent Literature 1: JP 2012-203359 A

### Summary of Invention

### Technical Problem

Meanwhile, in recent years, regulations on the use of persistent chemicals (Forever Chemicals), such as perfluoroalkyl compounds (PFAS), have been considered internationally for reasons such as reports of relevance of such chemicals to health hazards. The negative photosensitive resin composition of Patent Literature 1 contains, in some cases, a perfluoroalkyl group in the polybenzoxazole precursor from the viewpoint of transmittance to exposure light and developability, and may be subject to PFAS regulations. From now on, there is a demand for a negative photosensitive resin composition that can comply with the PFAS regulations and has properties equivalent to those of existing negative photosensitive resin compositions.

The present invention has been made in view of the above-described problems, and an object of the present invention is to provide a polyhydroxyamide compound capable of providing a new negative photosensitive resin composition free of a resin component that may be subject to PFAS regulations. Another object of the present invention is to provide a dry film including a resin layer formed of the negative photosensitive resin composition; a cured product formed of the negative photosensitive resin composition or the resin layer of the dry film; and an electronic component including the cured product.

### Solution to Problem

One aspect of the present invention is a polyhydroxyamide compound. The polyhydroxyamide compound contains a structural unit represented by the formula (1) and a structural unit represented by the formula (2): 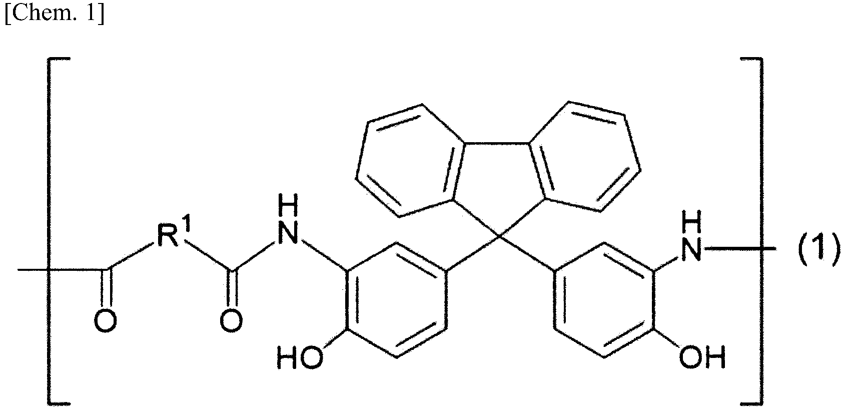
wherein R¹ is a divalent organic group; and 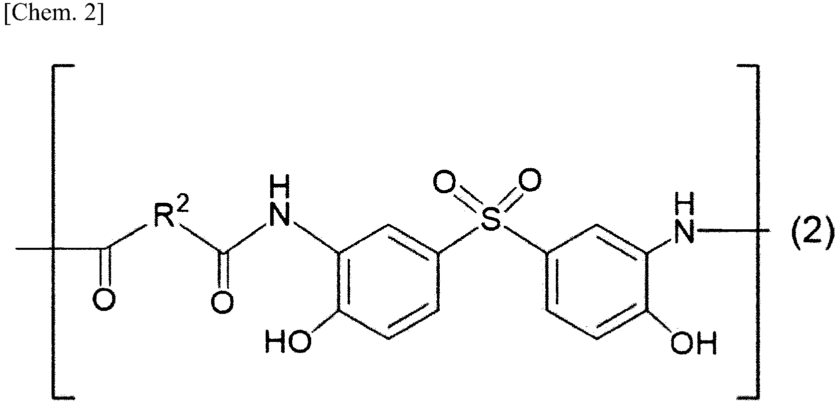
wherein R² is a divalent organic group.

In the polyhydroxyamide compound according to the above aspect, a ratio of number n₁ of structural units represented by the formula (1) to a sum of the number n₁ of structural units represented by the formula (1) and number n₂ of structural units represented by the formula (2), that is, [n₁/(n₁ + n₂)] is preferably 0.35 to 0.80.

In the negative photosensitive resin composition according to the above aspect, the polyhydroxyamide compound preferably has a weight average molecular weight of 2,000 to 20,000.

Another aspect of the present invention is a negative photosensitive resin composition. The negative photosensitive resin composition contains the polyhydroxyamide compound according to the above aspect.

Still another aspect of the present invention is a dry film. The dry film includes a resin layer formed of the negative photosensitive resin composition according to the above aspect.

Yet another aspect of the present invention is a cured product. The cured product is formed of the negative photosensitive resin composition according to the above aspect or the resin layer of the dry film according to the above aspect.

Yet still another aspect of the present invention is an electronic component. The electronic component includes the cured product according to the above aspect.

### Advantageous Effects of Invention

According to the present invention, it is possible to provide a polyhydroxyamide compound capable of providing a new negative photosensitive resin composition free of a resin component that may be subject to PFAS regulations. In addition, it is possible to provide a dry film including a resin layer formed of the negative photosensitive resin composition; a cured product formed of the negative photosensitive resin composition or the resin layer of the dry film; and an electronic component including the cured product.

### Description of Embodiments

Hereinafter, embodiments of the presently disclosed technique will be described in detail. In the present description, a notation "a to b" in the description of numerical ranges represents "a or more and b or less" unless otherwise specified.

In the present description, when a plurality of upper limits and a plurality of lower limits are described separately, all numerical ranges that can be defined by freely combining the upper limits and the lower limits shall be regarded as being described in the present description.

In the present description, when a compound is described, an isomer thereof is also regarded as being described together.

In the present description, the solid content means a component that constitutes a composition and is other than a solvent (in particular, an organic solvent) of the photosensitive resin composition or each raw material, and is based on mass unless otherwise specified.

### 1. Polyhydroxyamide compound

The polyhydroxyamide compound of the present embodiment contains a structural unit represented by the formula (1) and a structural unit represented by the formula (2). It is preferable that the polyhydroxyamide compound of the present embodiment does not have a perfluoroalkyl group in its structure.

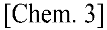

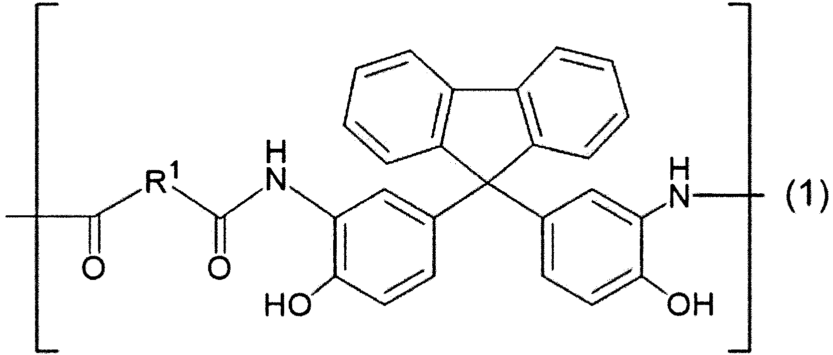

In the formula, R¹ is a divalent organic group.

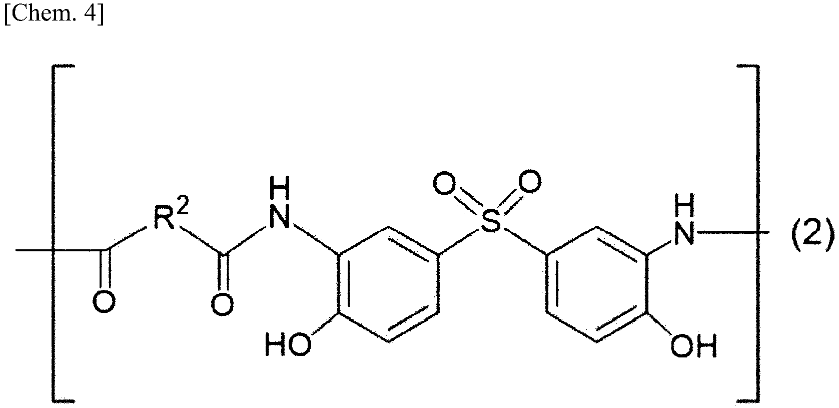

In the formula, R² is a divalent organic group.

R¹ in the formula (1) and R² in the formula (2) are not particularly limited as long as they are each a divalent organic group, and examples thereof include an alkylene group, a cycloalkylene group, an arylene group, an alkyl ether group, a ketone group, and an ester group. Among them, a divalent aromatic hydrocarbon group having a skeleton such as a benzene, naphthalene, perylene, biphenyl, diphenyl ether, diphenylsulfone, diphenylpropane, or benzophenone skeleton, or a divalent aliphatic hydrocarbon group having a skeleton such as a butane or cyclobutane skeleton is preferable. From the viewpoint of the resolution of the negative photosensitive resin composition and the insulation reliability of the cured product, the number of carbon atoms of each of R¹ and R² is preferably 4 to 30, and phenyl, biphenyl, and diphenyl ether are preferable. Two or more of the groups mentioned above can be incorporated as each of R¹ and R² in the molecule of the polyhydroxyamide compound. R¹ and R² may have the same structure or different structures.

The polyhydroxyamide compound may have an alkali-soluble group at the terminal. The alkali-soluble group at the terminal is not particularly limited, and examples thereof include functional groups such as an alcoholic hydroxyl group, a phenolic hydroxyl group, an acid anhydride group, a carboxyl group, a sulfonic acid group, a sulfonamide group, and an active methylene group. The polyhydroxyamide compound preferably has a carboxyl group or a phenolic hydroxyl group from the viewpoint of solubility in a developer.

Among these alkali-soluble groups, a phenolic hydroxyl group is particularly preferable. When the polyhydroxyamide compound has a phenolic hydroxyl group at the terminal, the solubility of the polyhydroxyamide compound in a developer can be improved. Furthermore, since the phenolic hydroxyl group is less reactive than the carboxyl group, an excessive reaction with a crosslinking agent is inhibited, and even when a PEB step is performed, the solubility of the unexposed portion in a developer can be maintained. As a result, the resolution is maintained, so that it is presumed that a negative photosensitive resin composition that enables formation of a finer L/S pattern having a high aspect ratio can be provided.

In addition, the alkali-soluble group contained at the terminal of the polyhydroxyamide compound may be a residue of a monomer that constitutes the polyhydroxyamide compound, or may be a terminal structure introduced by a terminal blocking agent having an alkali-soluble group. The alkali-soluble group contained at the terminal of the polyhydroxyamide compound is preferably a terminal structure introduced by a terminal blocking agent having an alkali-soluble group.

The terminal blocking agent is not particularly limited, and examples thereof include compounds having one amino group and a hydroxyl group, such as an aminophenol compound, a hydroxybenzylamine compound, an aminobenzyl alcohol compound, and an alcohol amine compound; compounds having one carboxyl group and a hydroxyl group, such as hydroxy acid; hydroxyl group-containing acid anhydride compounds, such as hydroxy acid anhydride; compounds having an amino group and a carboxyl group, such as aminobenzoic acid and amino acid; and acid anhydride compounds, such as phthalic anhydride and 5-norbornene-2,3-dicarboxylic anhydride.

The ratio of number n₁ of structural units represented by the formula (1) to the sum of the number n₁ of structural units represented by the formula (1) and number n₂ of structural units represented by the formula (2), that is, [n₁/(n₁ + n₂)] (hereinafter referred to as L) can be, for example, 0.10 to 0.90. L can be determined by subjecting the polyhydroxyamide compound to H-NMR measurement, and can be determined from an integrated intensity ratio of a peak derived from the structural unit represented by the formula (1) to a peak derived from the structural unit represented by the formula (2).

From the viewpoint of obtaining a polyhydroxyamide compound more suitable for use in the negative photosensitive resin composition, L is preferably 0.35 to 0.80. Since the structural unit represented by the formula (1) has a fluorene skeleton having high hydrophobicity, the structural unit is excellent in organic solvent solubility and can moderately reduce alkali solubility. Meanwhile, since the structural unit represented by the formula (2) is excellent in i-line transmittance and has a sulfonyl group having high hydrophilicity, the structural unit can improve alkali solubility. It is presumed that when L is in the above range, the polyhydroxyamide compound is more excellent in the balance of various properties, so that a polyhydroxyamide compound more suitable for use in the negative photosensitive resin composition can be obtained.

From the viewpoint of obtaining a negative photosensitive resin composition that facilitates formation of a finer pattern by the mechanism same as described above, L is more preferably 0.40 to 0.75, and still more preferably 0.45 to 0.60. The polyhydroxyamide compound of the present embodiment may contain a structural unit other than the structural units of the formula (1) and the formula (2).

Here, the structural unit refers to, for example, a monomer-derived structural unit {such as the structural unit of the formula (1) or the formula (2)} serving as a raw material in the production of the polyhydroxyamide compound by polymerization or copolymerization of raw materials. The concept of the monomer-derived structural unit also includes a case where a plurality of different monomer-derived structural units are bonded to form one structural unit.

The value of L can be adjusted by the blend of raw materials (monomers and the like) in producing the polyhydroxyamide compound. A method that can be used for producing the polyhydroxyamide compound is, for example, a method of copolymerizing raw materials, that is, a hydroxyamino compound represented by the formula (3) and the formula(4) and a dicarbonyl dichloride compound represented by the formula (5). The value of L can be adjusted by adjusting the blending amounts of these raw materials.

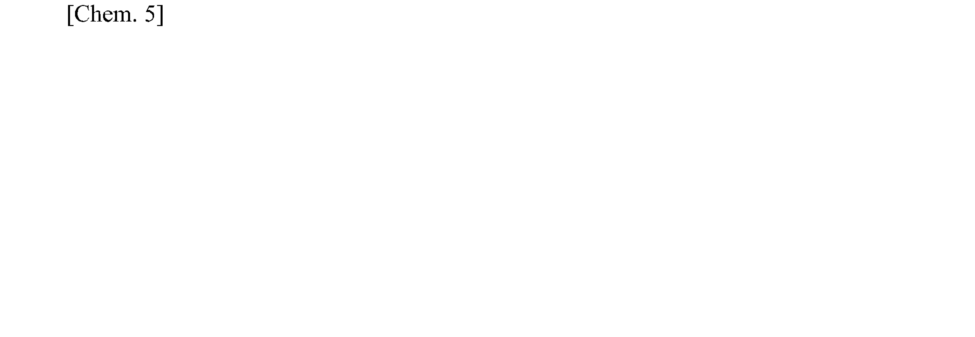

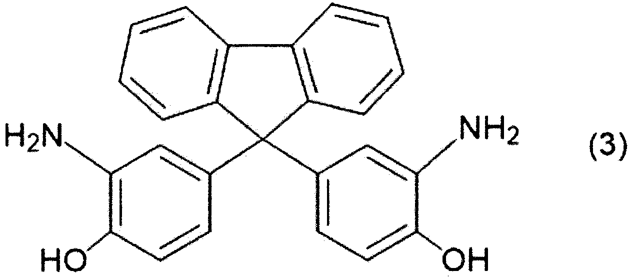

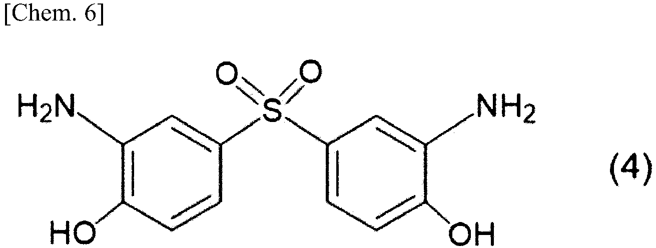

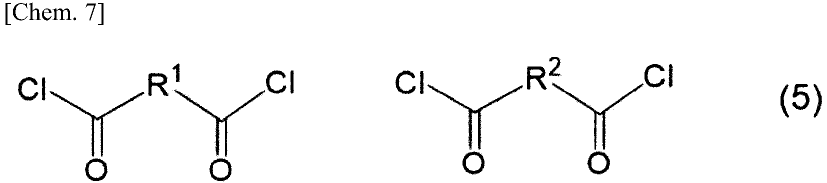

In the formula (5), R¹ and R² are as described above.

The dicarbonyl dichloride compound represented by formula (5) is not particularly limited, and examples thereof include terephthalic acid dichloride, 1,1'-biphenyl-4,4'-dicarbonyl dichloride, and a compound represented by formula (6), that is, 4,4'-oxybis(benzoyl chloride) (DEDC). In the present embodiment, DEDC is preferable.

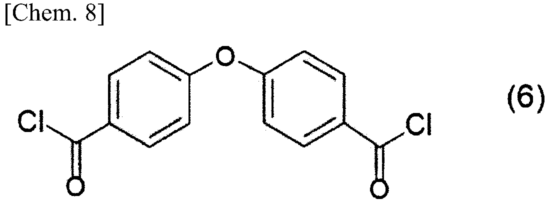

Other compounds that are copolymerizable with the above-described compounds may be copolymerized. Examples of the other copolymerizable compounds include a diol compound, an acid dianhydride, a diisocyanate compound, and a diamine compound different from the hydroxyamino compound represented by formula (3) or formula (4).

The weight average molecular weight (Mw) of the polyhydroxyamide compound can be 2,000 to 20,000, and is preferably 2,000 to 15,000, more preferably 3,000 to 15,000, and still more preferably 4,000 to 10,000. When the weight average molecular weight of the polyhydroxyamide compound is in the above range, it is possible to form a finer L/S pattern having a high aspect ratio.

The number average molecular weight (Mn) of the polyhydroxyamide compound is preferably 1,000 to 10,000, and more preferably 1,500 to 6,000.

The polydispersity index (PDI) of the polyhydroxyamide compound is preferably 1.5 to 5.0, and more preferably 1.5 to 4.5.

When the weight average molecular weight (Mw), the number average molecular weight (Mn), and the polydispersity index (PDI) of the polyhydroxyamide compound are in the above ranges, the solubility of the unexposed portion in a developer and the reaction with a crosslinking agent during exposure are suitably balanced, and a negative photosensitive resin composition having more excellent resolution can be obtained.

In the present description, the weight average molecular weight and the number average molecular weight are measured by gel permeation chromatography (GPC) (GL-7700 manufactured by GL Sience Inc.), and the numerical values are converted in terms of standard polystyrene. Specific measurement conditions are as follows.
Column: TSKgel α-M (manufactured by Tosoh Corporation)
Temperature in column: 40°C
Eluent composition: an NMP solution containing 100 mmol/L of H₃PO₄ (an 85% aqueous H₃PO₄ solution is used as a raw material) and 10 mmol/L of LiBr
Eluent flow rate: 0.5 mL/min
Standard reagent for calibration: polystyrene
Detector wavelength: 260 nm and 300 nm
Detector temperature: room temperature (about 25°C)
Baseline range during analysis: 15 to 40 minutes
Molecular weight calculation range during analysis: 20 to 35 minutes

In the present description, the polydispersity index (PDI) is calculated by the following the formula. $PDI = Mw / Mn$

The chlorine atom concentration (or chlorine ion concentration) of the molecular structure of the polyhydroxyamide compound is not particularly limited, and is preferably 5 ppm by mass or less with respect to the total mass of the polyhydroxyamide compound. The lower the chlorine atom concentration (or chlorine ion concentration) of the molecular structure of the negative photosensitive resin composition is, the easier it is to make the insulation reliability of the cured product more excellent.

The alkali dissolution rate of the polyhydroxyamide compound is not particularly limited, and can be, for example, 10 to 1,000 nm/sec, more preferably 50 to 700 nm/sec, and still more preferably 100 to 500 nm/sec from the viewpoint of obtaining a negative photosensitive resin composition excellent in developability and sensitivity. If the alkali dissolution rate is too low, the unexposed portion may not be sufficiently dissolved and pattern formation may be difficult, and if the alkali dissolution rate is too high, the sensitivity may be reduced or the pattern may swell during development. The alkali dissolution rate of the polyhydroxyamide compound can be measured by the method described in the section of Examples described later.

### 2. Negative photosensitive resin composition

The negative photosensitive resin composition of the present embodiment contains the above-described polyhydroxyamide compound. In addition, the negative photosensitive resin composition of the present embodiment preferably further contains a crosslinking agent, a photoacid generator, a basic compound, and the like. It is preferable that the negative photosensitive resin composition of the present embodiment does not substantially contain a compound having a perfluoroalkyl group from the viewpoint that the entire negative photosensitive resin composition should comply with the PFAS regulations.

### 2-1. Crosslinking agent

The crosslinking agent is not particularly limited, and a known crosslinking agent can be used. Examples thereof include a melamine compound, a guanamine compound, a triazine compound, an epoxy compound, an oxetane compound, an isocyanate compound, and an oxazoline compound. The crosslinking agent is preferably a compound having at least one selected from the group consisting of a methoxymethyl group and a methylol group. These functional groups cause a crosslinking reaction with a phenolic hydroxyl group or a carboxyl group contained in the polyhydroxyamide compound or the like by heating using an acid generated from the photoacid generator described later as an active species, and thus negative photolithography (pattern formation) is realized by exposure, PEB, and development treatment. In addition, when the negative photosensitive resin composition is further heated after pattern formation, the curing reaction of the negative photosensitive resin composition proceeds, and the cured product exhibits excellent properties.

The crosslinking agent desirably contains a heterocyclic ring in order to improve the resolution of the negative photosensitive resin composition and the insulation reliability of the product that is obtained after curing. The heterocyclic ring is not particularly limited, and contains one or more heteroatoms such as boron, nitrogen, oxygen, phosphorus, sulfur, antimony, arsenic, bismuth, selenium, silicon, tellurium, and tin atoms. Examples of the heterocyclic ring include a 3-membered, 4-membered, 5-membered, 6-membered, 7-membered, and 8-membered saturated and unsaturated rings. From the viewpoint of the resolution of the negative photosensitive resin composition and the insulation reliability of the cured product, the heterocyclic ring is preferably a heterocyclic ring containing a nitrogen atom, and more preferably a heterocyclic ring containing a plurality of nitrogen atoms.

Specifically, from the viewpoint of being capable of providing a composition, compounds having a triazine structure containing a triazine ring, such as hexamethylolmelamine and hexamethoxymethylmelamine, compounds having a guanamine structure, such as tetramethylol benzoguanamine and tetramethoxymethyl benzoguanamine, compounds having a glycoluril structure, such as tetramethylolglycoluril and tetramethoxyglycoluril, and compounds having an imidazolidinone structure, such as 1,3-bis(methoxymethyl)-2-imidazolidinone are more preferable. Among them, in particular, compounds having a triazine structure containing a triazine ring and compounds having a guanamine structure can be preferably used from the viewpoint of being capable of providing a negative photosensitive resin composition that enables formation of a finer L/S pattern having a high aspect ratio.

### 2-2. Photoacid generator

The photoacid generator is not particularly limited as long as it is a compound that generates an acid by irradiation with light such as ultraviolet rays or visible light, and examples thereof include naphthoquinone diazide compounds, diaryl sulfonium salts, triaryl sulfonium salts, dialkyl phenacyl sulfonium salts, diaryl iodonium salts, aryl diazonium salts, aromatic tetracarboxylic acid esters, aromatic sulfonic acid esters, nitrobenzyl esters, aromatic N-oxyamide sulfonates, aromatic N-oxyimide sulfonates, aromatic sulfamides, oxime sulfonate compounds, naphthalimides, and benzoquinone diazosulfonic acid esters. These can be used alone or in combination of two or more thereof at any ratio. The photoacid generator is preferably an oxime sulfonate compound from the viewpoint of making the resolution and insulation reliability more excellent, and more preferably one containing the structure of the formula (7): 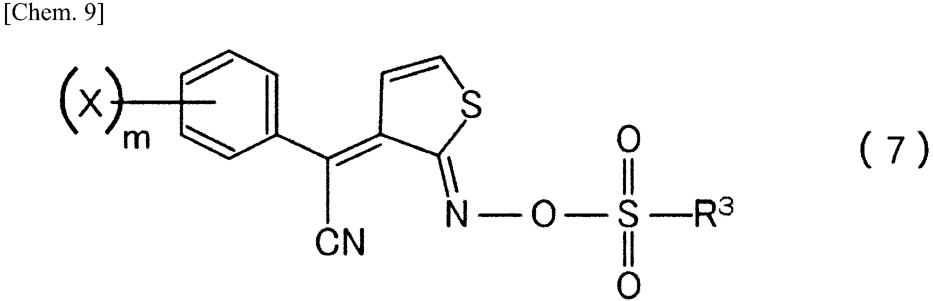 wherein X is a hydrocarbon group or a halogen atom, m is an integer of 0 to 3, and R³ is a hydrogen atom, a hydrocarbon group, an organic group containing a ketone group, or a halogen atom.

X in the formula (7) is not particularly limited, and may be, for example, a hydrocarbon group (for example, an alkyl group, an alkenyl group, an alkynyl group, or an aryl group) or a halogen atom. The hydrocarbon group may have a substituent, and may have a linear, branched, or cyclic structure. The hydrocarbon group is preferably a linear or branched hydrocarbon group having 1 to 4 carbon atoms. The halogen atom is preferably a chlorine atom or a fluorine atom.

m in the formula (7) represents an integer of 0 to 3, and is preferably 0 or 1. When m is 2 or 3, a plurality of Xs may be the same or different.

R³ in the formula (7) is preferably a hydrogen atom, a hydrocarbon group, an organic group containing a ketone group, or a halogen atom. The hydrocarbon group (for example, an alkyl group, an alkenyl group, an alkynyl group, or an aryl group) may be unsubstituted or substituted with a halogen atom.

The hydrocarbon group is preferably a linear, branched, or cyclic hydrocarbon group having 1 to 20 carbon atoms, and more preferably a linear, branched, or cyclic hydrocarbon group having 1 to 10 carbon atoms. The halogen atom may be a chlorine atom or a fluorine atom.

Examples of commercially available oxime sulfonate compounds include Irgacure PAG103, Irgacure PAG108, Irgacure PAG121, and Irgacure PAG203 manufactured by BASF.

### 2-3. Basic compound

The negative photosensitive resin composition of the present embodiment preferably contains a basic compound. In particular, when the negative photosensitive resin composition of the present embodiment contains a basic compound, the acid generated from the photoacid generator by exposure can be inhibited from diffusing to the unexposed portion, so that the resolution can be improved, and the generation of a development residue in the unexposed portion after development can be prevented.

The basic compound is not particularly limited, and examples thereof include amine compounds such as trimethylamine, diethylamine, triethylamine, N,N-diisopropylethylamine, di-n-propylamine, tri-n-propylamine, tri-n-pentylamine, tribenzylamine, diethanolamine, triethanolamine, tris(2-methoxy)amine, bis(2-methoxy)amine, tris(2-ethoxy)amine, bis(2-ethoxy)amine, N-methyldiethanolamine, N-ethyldiethanolamine, N,N-dimethylethanolamine, n-hexylamine, n-heptylamine, n-octylamine, n-nonylamine, ethylenediamine, N,N,N',N'-tetramethylethylenediamine, tetramethylenediamine, hexamethylenediamine, 4,4'-diaminodiphenylmethane, 4,4'-diaminodiphenyl ether, 4,4'-diaminobenzophenone, and 4,4'-diaminodiphenylamine; amide compounds such as formamide, N-methylformamide, N,N-dimethylformamide, acetamide, N-methylacetamide, N,N-dimethylacetamide, propionamide, and benzamide; lactams such as pyrrolidone and N-methylpyrrolidone; urea compounds such as methylurea, 1,1-dimethylurea, 1,3-dimethylurea, 1,1,3,3-tetramethylurea, and 1,3-diphenylurea; nitrogen-containing heterocyclic compounds such as imidazole, benzimidazole, 4-methylimidazole, 8-oxyquinoline, acridine, purine, pyrrolidine, piperidine, 2,4,6-tri(2-pyridyl)-S-triazine, piperazine, 1,4-dimethylpiperazine, 1,4-diazabicyclo[2.2.2]octane, and pyridine; and morpholine compounds such as morpholine and 4-methylmorpholine. These can be used alone or in combination of two or more thereof at any ratio. Among them, amine compounds are preferable, alcohol amines such as N-methyldiethanolamine, N-ethyldiethanolamine, and N,N-dimethylethanolamine are more preferable, and diethanolamine, triethanolamine, N-methyldiethanolamine, N-ethyldiethanolamine, and N,N-dimethylethanolamine are still more preferable.

### 2-4. Solvent

The negative photosensitive resin composition of the present embodiment can contain a solvent. The solvent is not particularly limited, and examples thereof include ethers, esters, glycol esters, ketones, lactones, lactams, sulfoxides, tetramethylurea, dimethylsulfone, and pyridine.

Examples of the ethers include 2-methoxy-1-methylethyl acetate (PGMEA), ethylene glycol dimethyl ether, diethylene glycol dimethyl ether, diethylene glycol diethyl ether, diethylene glycol methyl ethyl ether, propylene glycol dimethyl ether, dipropylene glycol dimethyl ether, ethylene glycol monomethyl ether, ethylene glycol monoethyl ether, diethylene glycol monomethyl ether, diethylene glycol monoethyl ether, propylene glycol monomethyl ether, propylene glycol monoethyl ether, dipropylene glycol monomethyl ether, and dipropylene glycol monoethyl ether.

Examples of the esters include ethyl acetate, butyl acetate, ethyl lactate, methyl 3-methoxypropionate, methyl 2-methoxypropionate, ethyl 3-methoxypropionate, ethyl 2-methoxypropionate, ethyl 3-ethoxypropionate, and ethyl 2-ethoxypropionate.

Examples of the ketones include methyl ethyl ketone; methyl isobutyl ketone (4-methyl-2-pentanone); 2-heptanone;
cycloalkanones that are monoketones, such as cyclopropanone, cyclobutanone, cyclopentanone, cyclohexanone, methylcyclohexanone, cycloheptanone, cyclooctanone, 2-norbornanone, 2-methylcyclohexanone, 4-methylcyclohexanone, 3-methylcyclohexanone, and 2,2-dimethylcyclopentanone;
cycloalkanones that are diketones, such as 1,3-cyclopentanedione, 3-methyl-1,2-cyclopentanedione, 1,2-cyclohexanedione, 1,3-cyclohexanedione, 1,4-cyclohexanedione, and 2-methyl-1,3-cyclopentanedione;
cycloalkenones such as 4-methyl-2-cyclopentenone, 2-cyclohexenone, 2-cyclopentene-1-one, and 2-cyclohexene-1-one; and
cyclic ketones having a heterocyclic skeleton, such as 2-azetidinone, 4,5-dihydro-3(2H)-thiophenone, 4-oxothiane, and dihydrolevoglucosenone.

Examples of the glycol esters include carbitol acetate, ethyl cellosolve acetate, and ethylene glycol monoethyl ether acetate.

Examples of the lactones include γ-butyrolactone, examples of the lactams include N-methylpyrrolidone and N-methylcaprolactam, and examples of the sulfoxides include dimethyl sulfoxide and hexamethyl sulfoxide.

These solvents can be used alone or in combination of two or more thereof at any ratio. Among these solvents, lactones and cyclic ketones are preferable, and γ-butyrolactone and cyclopentanone are preferable from the viewpoint of excellent affinity with the components in the negative photosensitive resin composition. In addition, from the viewpoint of excellent solvent removability during drying of the negative photosensitive resin composition and compatibility to an edge rinse step in semiconductor production, cyclic ketones are preferable, cycloalkanones that are monoketones are more preferable, cyclopropanone, cyclobutanone, cyclopentanone, cyclohexanone, methylcyclohexanone, cycloheptanone, cyclooctanone, 2-norbornanone, 2-methylcyclohexanone, 4-methylcyclohexanone, 3-methylcyclohexanone, and 2,2-dimethylcyclopentanone are still more preferable, and cyclopentanone is particularly preferable.

### 2-5. Other components

The negative photosensitive resin composition of the present embodiment can contain other components as long as the effects of the presently disclosed technique are not impaired. As the other components, known components that can be incorporated in the negative photosensitive resin composition can be used, and examples thereof include fillers, adhesion promoters, surfactants, plasticizers, thermal acid generators, sensitizers, leveling agents, colorants, fibers, and fine particles.

The surfactant is not particularly limited, and examples thereof include a fluorochemical surfactant and a silicone-containing surfactant. Examples of commercially available products of the fluorochemical surfactant include "MEGAFACE" series (for example, MEGAFACE F-281, F-477, F-553, F-554, F-555, F-556, F-557, F-558, F-559, F-560, F-561, F-563, and F-569) manufactured by DIC Corporation. Examples of commercially available products of the silicone-containing surfactant include surface conditioner series (for example, BYK-302, BYK-307, BYK-310, BYK-322, BYK-323, BYK-326, BYK-331, BYK-332, BYK-333, BYK-348, BYK-349, BYK-377, BYK-378, BYK-3455, and BYK-3760) manufactured by BYK-Chemie GmbH. These may be used alone or in combination of two or more kinds thereof.

### 3. Preparation of negative photosensitive resin composition

The negative photosensitive resin composition of the present embodiment can be obtained by mixing the above-described polyhydroxyamide compound and optional components including the crosslinking agent, the photoacid generator, the basic compound, and the like. The components can be mixed under heating as necessary.

### 3-1. Polyhydroxyamide compound

The content of the polyhydroxyamide compound can be set to 50 to 80 mass% with respect to the total mass of the solid content of the negative photosensitive resin composition, which is defined as 100 mass%. Here, the mass of the solid content in the present description refers to the mass of a residue obtained by completely volatilizing a volatile component.

### 3-2. Crosslinking agent

The content of the crosslinking agent can be set to 10 to 40 mass% with respect to the total mass of the solid content of the negative photosensitive resin composition, which is defined as 100 mass%. When the crosslinking agent has a methoxymethyl group and/or a methylol group, the content of the crosslinking agent can be set such that the ratio of the number of methoxymethyl groups and/or methylol groups contained in the crosslinking agent to the number of phenolic hydroxyl groups contained in the negative photosensitive resin composition (that is, the ratio of methoxymethyl group and/or methylol group : phenolic hydroxyl group) is 120 : 100 to 200 : 100. When the ratio is set in the above range, it is possible to make the resolution of the negative photosensitive resin composition and the insulation reliability of the product that is obtained after curing more excellent.

### 3-3. Photoacid generator

The content of the photoacid generator can be set to 0.5 to 10 mass%, and is preferably 1 to 5 mass% with respect to the total mass of the solid content of the negative photosensitive resin composition, which is defined as 100 mass%.

### 3-4. Basic compound

When the basic compound is added, the content thereof can be set to 0.01 to 0.50 mass%, and is preferably 0.08 to 0.40 mass% with respect to the total mass of the solid content of the negative photosensitive resin composition, which is defined as 100 mass%. When the content of the basic compound is in the above range, after the negative photosensitive resin composition is developed, the generation of a development residue in the unexposed portion is easily inhibited.

### 4. Dry film

The dry film of the present embodiment includes a substrate, and a resin layer formed on the substrate using the negative photosensitive resin composition of the present embodiment. In order to protect the resin layer, a protective film may be further laminated on the surface of the resin layer.

The resin layer can be obtained, for example, by applying the negative photosensitive resin composition onto the substrate, adjusting the thickness of the resulting resin layer using a comma coater, a blade coater, a lip coater, a rod coater, a squeeze coater, a reverse coater, a transfer roll coater, a gravure coater, a spray coater or the like, and drying the resin layer. The thickness of the resin layer is not particularly limited, and may be set to 1 to 150 µm depending on the use.

The substrate is not particularly limited, and may be, for example, a metal foil such as a copper foil; or a film such as a polyimide film, a polyester film, or a polyethylene naphthalate (PEN) film.

The protective film is not particularly limited, and a polyethylene film, a polytetrafluoroethylene film, a polypropylene film, paper, or the like can be used. The protective film is preferably selected such that the adhesive force between the protective film and the resin layer is lower than the adhesive force between the substrate and the resin layer. In order to make the adhesive force between the protective film and the resin layer lower than the adhesive force between the substrate and the resin layer, a film obtained by subjecting the surface of the protective film to release treatment can be used.

### 5. Cured product

The cured product of the present embodiment is obtained by curing the negative photosensitive resin composition or the resin layer of the dry film described above. The cured product may be a patterned cured product. Examples of the method for producing a patterned cured product include the following method.

### 5-1. Dry coating film forming step

The dry coating film forming step is a step of applying the above-described negative photosensitive resin composition onto a substrate to form a coating film, and then drying the coating film. In the dry coating film forming step, it is also possible to form a dry coating film on the substrate by transferring the resin layer of the dry film onto the substrate.

The method for applying the negative photosensitive resin composition onto the substrate is not particularly limited, and examples thereof include a method for applying the negative photosensitive resin composition using a spin coater, a bar coater, a blade coater, a curtain coater, a screen printer, or the like, a method for applying the negative photosensitive resin composition by spraying with a spray coater, and an inkjet method. The coating film thickness is not particularly limited, and can be, for example, 10 µm or less, 5 µm or less, or 3 µm or less. A small film thickness makes it possible to form a finer L/S pattern while maintaining the aspect ratio of the pattern.

The method for drying the coating film is not particularly limited, and examples thereof include air blow drying, drying by heating using an oven or a hot plate, and vacuum drying. Conditions for drying by heating are, for example, a heating temperature of 70 to 140°C and a drying time of 1 to 30 minutes.

The transfer of the resin layer of the dry film onto the substrate is preferably performed under pressure and heating using a vacuum laminator or the like. The heating temperature can be set to, for example, 60 to 100°C.

The substrate is not particularly limited, and may be, for example, a printed wiring board having a circuit formed thereon, a flexible printed wiring board, or a wafer having a semiconductor element formed thereon.

### 5-2. Exposure step

The exposure step is a step of irradiating the dry coating film formed in the dry coating film forming step with radiation through a photomask that enables formation of a desired pattern, thereby exposing the photoacid generator in the exposed portion to light to generate an active species. When the patterning is not required, it is not necessary to use a photomask. Alternatively, a pattern may be directly drawn with a laser using a direct drawing apparatus.

As for the wavelength of the radiation, radiation having a wavelength capable of activating the photoacid generator is used, and radiation having a maximum wavelength of 410 nm or less is preferable in order to perform miniaturized patterning. The irradiation energy can be adjusted, for example, by the thickness of the formed dry coating film, and can be set to, for example, 10 to 1500 mJ/cm². As the exposure light source, a high-pressure mercury lamp, an ultra-high-pressure mercury lamp, a metal halide lamp, a mercury short arc lamp, a KrF laser, or the like can be used.

### 5-3. PEB step

The PEB step is a step of heat-treating the dry coating film exposed in the exposure step to impart development resistance to the exposed portion of the dry coating film (hereinafter sometimes abbreviated as an exposed portion). In the PEB step, a crosslinking reaction between the polyhydroxyamide compound or a compound containing a phenolic hydroxyl group and the crosslinking agent proceeds using, as an active species, the acid generated from the photoacid generator in the exposed portion, and the exposed portion is insolubilized in the developer. The heating temperature in the PEB step can be set to 90 to 150°C, and the heating time can be set to 0.5 to 10 minutes. The heating can be performed by a known method such as a hot plate or a heating oven.

### 5-4. Development step

The development step is a step of treating the dry coating film heated in the PEB step with a developer, and dissolving and removing the unexposed portion of the dry coating film with the developer, thereby obtaining a patterned coating film. As for the developing method, a known method can be used, and examples thereof include a rotary spraying method, a paddle method, and a dipping method with ultrasonic treatment.

As for the developer, a known developer can be used, and examples thereof include aqueous solutions of inorganic alkalis such as sodium hydroxide, sodium carbonate, sodium silicate, and ammonia water, organic amines such as ethylamine, diethylamine, triethylamine, and triethanolamine, and quaternary ammonium salts such as tetramethylammonium hydroxide and tetrabutylammonium hydroxide. A watersoluble organic solvent such as methanol, ethanol, or isopropyl alcohol, or a surfactant can be added as necessary.

After the treatment with the developer, the coating film can be washed with a rinse liquid as necessary to provide a patterned coating film. The rinse liquid is not particularly limited, and examples thereof include pure water, methanol, ethanol, and isopropyl alcohol. These can be used alone or in combination of two or more thereof at any ratio.

### 5-5. Post-development heating step

The post-development heating step is a step of heating the patterned coating film formed in the development step to complete curing of the patterned coating film, thereby obtaining a cured patterned coating film (cured product). The heating temperature can be set to 150 to 200°C, and the heating time can be set to 1 to 120 minutes. The heating can be performed by a known method such as a hot plate or an inert oven, and it is desirable to perform the heating in a nitrogen atmosphere.

### 6. Use of negative photosensitive resin composition

The negative photosensitive resin composition of the present embodiment can be suitably used as a material for forming a display device, a semiconductor element, an electronic component, an optical component, a building material, and the like. The material for forming a semiconductor element is, for example, a resist material, a buffer coat film, or an insulating film for a redistribution layer for a wafer-level package (WLP). Examples of the material for forming an electronic component include a printed wiring board, an interlayer insulating film, and a wiring coating film.

### Examples

Hereinafter, the present invention will be described with reference to examples and comparative examples, but the present invention is not limited thereto. The components used in the examples and comparative examples are as follows.

### <Polyhydroxyamide compound>

Polyhydroxyamide compounds A-1 to A-8 were synthesized as follows. The components of each polyhydroxyamide compound, the molar ratios of the added components, and the value of [n₁/(n₁ + n₂)], the weight average molecular weight, the number average molecular weight, and the polydispersity index of the obtained polyhydroxyamide compounds A-1 to A-8 are shown in Table 1. The value of [n₁/(n₁ + n₂)] was determined by H-NMR, and the values of the molecular weights were measured by the method described above using GPC.

### (Synthesis Example 1: polyhydroxyamide compound (A-1))

### (Mn: 2,400, Mw: 6,300)

In a 120 mL vial (room temperature) equipped with a stirrer and a thermometer, 4.63 g (12.2 mmol) of 9,9-bis(3-amino-4-hydroxyphenyl)fluorene (BAHF) and 0.5 g (4.6 mmol) of 3-aminophenol (3AP) were stirred and dissolved in 20.8 g of N-methylpyrrolidone (NMP) for 15 minutes. Thereafter, the vial was immersed in an ice bath, 3.79 g (12.8 mmol) of 4,4'-oxybis(benzoyl chloride) (DEDC) was added as a solid over 10 minutes while the inside of the vial was kept at 0 to 5°C, and the resulting mixture was stirred in an ice bath for 30 minutes. After stirring at room temperature for 18 hours, the solution was charged into a large amount of ion-exchanged water, and a precipitate was collected. The resulting solid was dissolved in 33 g of cyclopentanone. Thereto was added 5 g of an anion exchange resin (AMBERLYST B-20 manufactured by ORGANO CORPORATION), and the resulting mixture was vigorously stirred for 1 hour. The stirred solution was concentrated and then charged into a large amount of ion-exchanged water, and a precipitate was collected. The precipitated solid was collected and then dried under reduced pressure to give a polyhydroxyamide compound (A-1).

### (A-1) Polyhydroxyamide compound

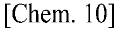

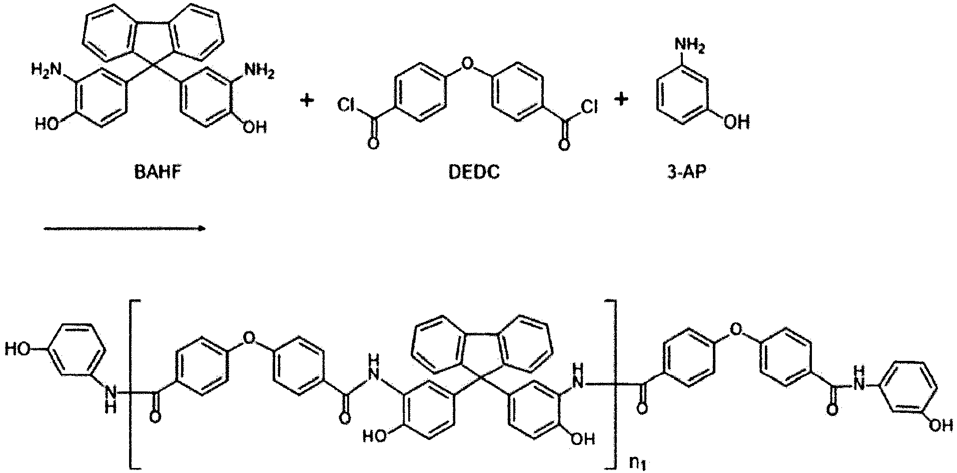

### (Synthesis Example 2: polyhydroxyamide copolymer compound (A-2))

### (Mn: 4,900, Mw: 12,100) (n₁ = 25, n₂ = 75)

A polyhydroxyamide compound (A-2) was obtained in the same manner as in Synthesis Example 1 except that in a 120 mL vial (room temperature) equipped with a stirrer and a thermometer, 1.16 g (3.1 mmol) of 9,9-bis(3-amino-4-hydroxyphenyl)fluorene (BAHF), 2.57 g (9.16 mmol) of 2,2-bis(3-amino-4-hydroxyphenyl) sulfone (SO₂AP), and 0.45 g (4.44 mmol) of 3-aminophenol (3AP) were stirred and dissolved in 18.6 g of N-methylpyrrolidone (NMP), and thereafter, the vial was immersed in an ice bath, and 3.78 g (12.8 mmol) of 4,4'-oxybis(benzoyl chloride) (DEDC) was added while the inside of the vial was kept at 0 to 5°C.

### (A-2) Polyhydroxyamide copolymer compound

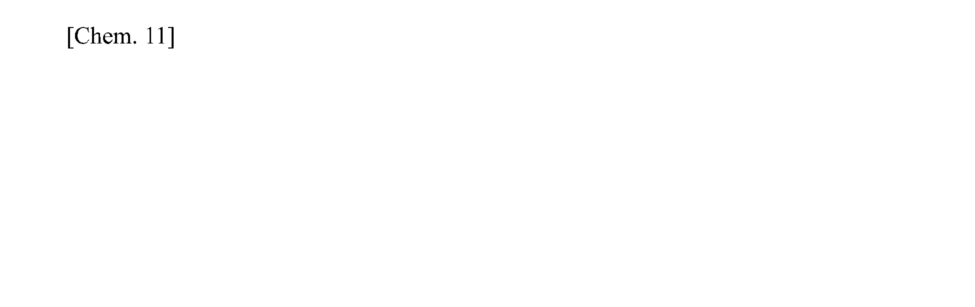

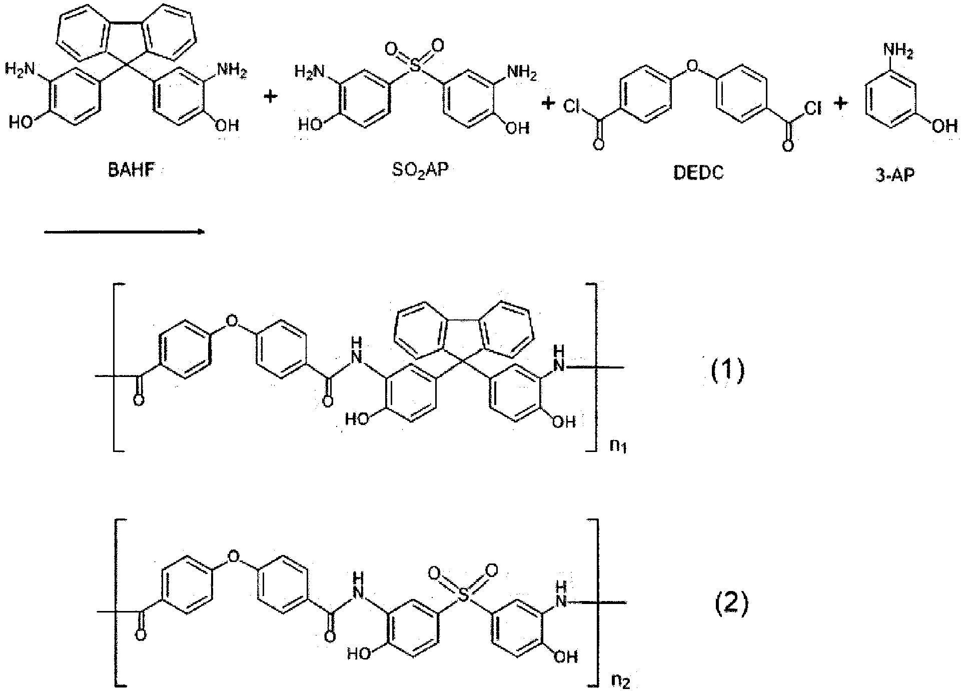

*Polyhydroxyamide copolymer compound containing the formula (1) and the formula (2)

### (Synthesis Examples 3 to 5: polyhydroxyamide copolymer compounds (A-3) to (A-5))

Polyhydroxyamide compounds (A-3) to (A-5) were obtained in the same manner as in Synthesis Example 2 except that the molar ratios of the added components including 9,9-bis(3-amino-4-hydroxyphenyl)fluorene (BAHF), 2,2-bis(3-amino-4-hydroxyphenyl) sulfone (SO₂AP), 3-aminophenol (3AP), and 4,4'-oxybis(benzoyl chloride) (DEDC) were as shown in Table 1.

### (Synthesis Example 6: polyhydroxyamide compound (A-6))

### (Mn: 2,500, Mw: 9,800)

A polyhydroxyamide compound (A-7) was obtained in the same manner as in Synthesis Example 1 except that 6.85 g (24.4 mmol) of 2,2-bis(3-amino-4-hydroxyphenyl) sulfone (SO₂AP) was used in place of 9,9-bis(3-amino-4-hydroxyphenyl)fluorene (BAHF), and that 0.86 g (7.87 mmol) of 3-aminophenol (3AP), 35 g of N-methylpyrrolidone (NMP), and 7.54 g (25.5 mmol) of 4,4'-oxybis(benzoyl chloride) (DEDC) were used.

### (A-6) Polyhydroxyamide compound

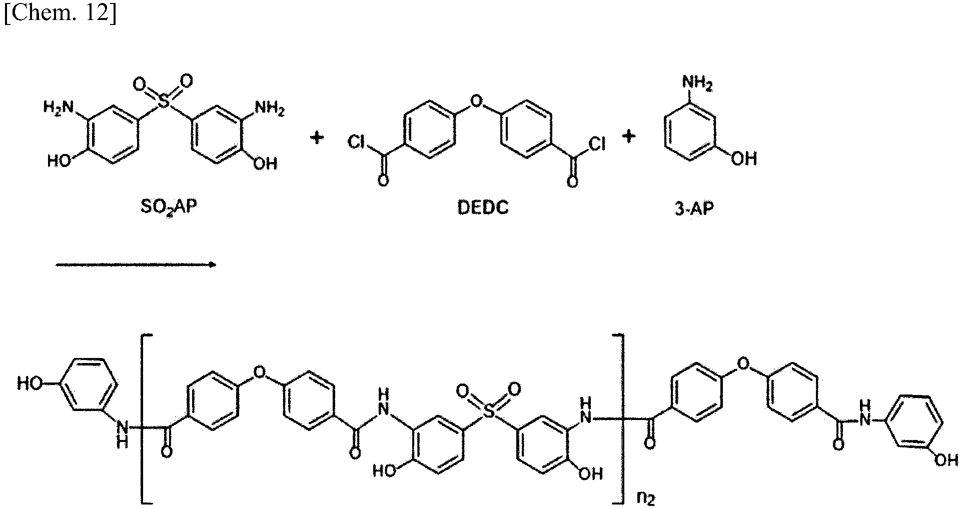

### (Synthesis Example 7: polyhydroxyamide compound (A-7))

### (Mn:3,200, Mw: 9,500)

A polyhydroxyamide compound (A-8) was obtained in the same manner as in Synthesis Example 1 except that 16.3 g (44.5 mmol) of 2,2-bis(3-amino-4-hydroxyphenyl) hexafluoropropane (6FAP) was used in place of 9,9-bis(3-amino-4-hydroxyphenyl)fluorene (BAHF), and that 1.80 g (22.0 mmol) of 3-aminophenol (3AP), 80 g of N-methylpyrrolidone (NMP), and 16.4 g (55.5 mmol) of 4,4'-oxybis(benzoyl chloride) (DEDC) were used.

### (A-7) Polyhydroxyamide compound

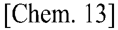

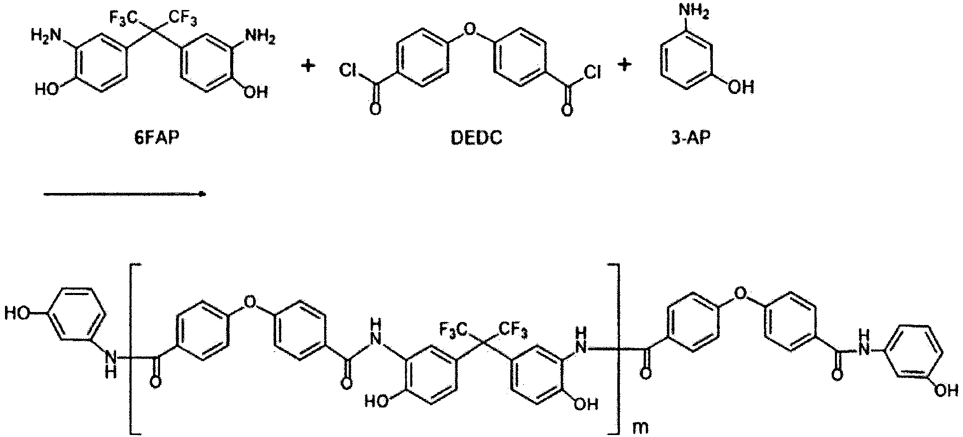

The polyhydroxyamide compounds were evaluated as follows. The evaluation results are shown in Table 1.

### (Evaluation of i-line transmittance)

A cyclopentanone solution having a solid content concentration of 20 mass% was prepared using each of the polyhydroxyamide compounds obtained in the synthesis examples, then spin-coated on quartz glass so that the dried film might have a film thickness of 3 µm, and dried by heating at 90°C for 3 minutes using a hot plate to form a dry coating film of the polyhydroxyamide compound. The transmission spectrum of the dry coating film was measured using a UV-Visible Spectrophotometer (Jasco V-570 manufactured by JASCO Corporation). The transmission spectrum was measured under the conditions of a bandwidth of 5 nm, a scanning speed of 400 nm/min, and a data reading interval of 1 nm. The transmittance for i-line (wavelength: 365 nm) as an exposure wavelength was evaluated according to the following evaluation criteria.

### (Evaluation criteria)

A: The i-line transmittance is 70% or more and less than 80%
B: The i-line transmittance is 40% or more and less than 70%
C: The i-line transmittance is less than 40%

### (Evaluation of alkali solubility)

A 20 mass% cyclopentanone solution was prepared using each of the polyhydroxyamide compounds obtained in the synthesis examples, then spin-coated on a silicon substrate, and dried by heating at 90°C for 3 minutes using a hot plate to form a dry coating film of the polyhydroxyamide compound. The initial film thickness of the dry coating film was measured by an optical interference type film thickness meter, development was then performed using a 2.38% aqueous tetramethylammonium hydroxide (TMAH) solution at 25°C, the dissolution time of the dry coating film was measured, and the alkali dissolution rate was calculated from the following the formula. Alkali dissolution rate (nm/s) = initial film thickness (nm)/dissolution time (s)

### (Evaluation criteria)

A: The dissolution rate is 50 nm/s or more and 500 nm/s or less
B: The dissolution rate is more than 500 nm/s and 1,000 nm/s or less
C: The dissolution rate is more than 1,000 nm/s
D: The sample has no alkali solubility or has a very low alkali dissolution rate (less than 50 nm/s), and the dissolution time cannot be measured.

### (Evaluation of solvent solubility)

The solubility of each of the polyhydroxyamide compounds obtained in the synthesis examples in cyclopentanone and propylene glycol monomethyl ether (PGME) was determined. In the case of preparing a negative photosensitive resin composition using a polyhydroxyamide compound having low solubility in cyclopentanone, the negative photosensitive resin composition was prepared using a mixed solvent of cyclopentanone and dimethyl sulfoxide.

### (Evaluation criteria)

A: The sample is soluble in both cyclopentanone and PGME
B: The sample is insoluble in cyclopentanone and soluble in PGME, or soluble in cyclopentanone and insoluble in PGME
C: The sample is insoluble in both cyclopentanone and PGME

**[Table 1]**

| | Molar ratios of charged components at polymerization | | | | | n₁/ (n₁₊n₂) | Mn | Mw | POI | i-Line transmittance | **Alkal** solublity | Solvent solubility |
|---|---|---|---|---|---|---|---|---|---|---|---|---|
| | DEDC | BAHF | SO₂AP | 6 FAP | 3AP | | | | | | | |
| A-1 | 100 | 95 | - | - | 38 | 1.00 | 2,400 | 6,300 | 2.6 | B | D | A |
| A-2 | 100 | 25 | 75 | - | 35 | 0.27 | 4,900 | 12,100 | 2.5 | B | B | B |
| A-3 | 100 | 40 | 60 | - | 45 | 0.37 | 3,600 | 9,200 | 2.6 | B | A | B |
| A-4 | 100 | 50 | 50 | - | 46 | 0.49 | 3,400 | 8,400 | 2.5 | B | A | A |
| A-5 | 100 | 75 | 25 | - | 32 | 0.78 | 2,700 | 7,400 | 2.7 | B | A | A |
| A-6 | 100 | - | 96 | - | 31 | 0.00 | 2,500 | 9,800 | 3.9 | A | C | C |
| A-7 | 100 | - | - | 80 | 40 | - | 3,200 | 9,500 | 2.9 | A | A | A |

The molar ratios of the added components in Table 1 each represent mol% of each component with respect to the charged amount of DEDC, which is defined as 100 mol%.

### <Crosslinking agent>

(B-1) MW-390 (a hexamethoxymethylmelamine compound manufactured by NIPPON CARBIDE INDUSTRIES CO., INC.)

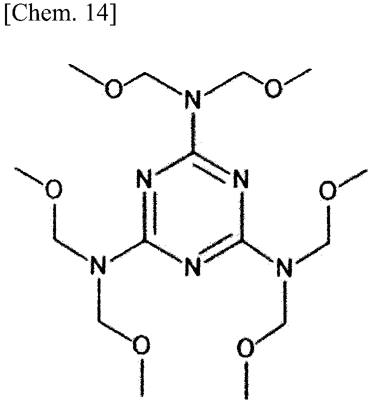

### <Photoacid generator>

(C-1) PAG-103 (an oxime sulfonate compound manufactured by BASF)

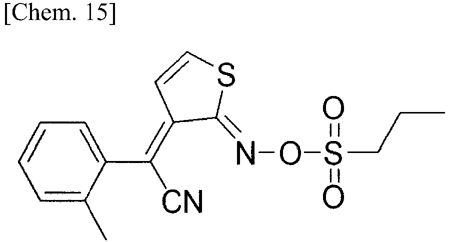

### <Basic compound>

(D-1) Triethanolamine (TEA)

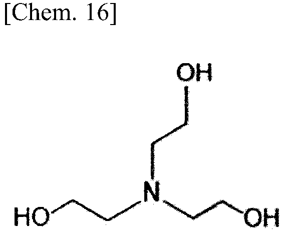

### <Solvent>

Cyclopentanone (manufactured by Tokyo Chemical Industry Co., Ltd.)
Dimethyl sulfoxide (DMSO) (manufactured by FUJIFILM Wako Pure Chemical Corporation)

### <Preparation of negative photosensitive resin composition>

Components in the amounts shown in Table 2 below were blended, and dissolved in a solvent and adjusted so that the resulting varnish might have a nonvolatile component concentration of 30% to give a varnish of a negative photosensitive resin composition of each of the examples and comparative examples. As for the blending amounts of the components in Table 2, the blending amounts except for the blending amount of the solvent are shown in parts by mass of the solid content.

### <Evaluation>

The obtained negative photosensitive resin compositions of examples and comparative examples were evaluated as follows. The evaluation results are shown in Table 2.

### (Evaluation of resolution and sensitivity)

The varnish of each of the examples and comparative examples was applied onto a silicon wafer using a spin coater so that the cured film might have a film thickness of 3.0 µm, and dried at 90°C for 3 minutes using a hot plate to give a dry coating film of the negative photosensitive resin composition of each of the examples and comparative examples. The dry coating film was exposed to a test pattern having an L/S of 2/2 µm to 10/10 µm at an interval of 1 µm using a contact exposure device (UVE-251S + EL-100 (manufactured by SAN-EI ELECTRIC CO., LTD.)), and subjected to post-exposure bake (PEB) for 60 seconds using a hot plate. The heating temperature in the PEB step was 120°C. Thereafter, the dry coating film was developed for 30 seconds using a 2.38% aqueous TMAH solution, rinsed with ultrapure water for 30 seconds, and spin-dried for 30 seconds to give a sample having a pattern.

Each sample was cut so that a cross section perpendicular to the longitudinal direction of the pattern could be observed. The cut surface of the pattern was observed using a scanning electron microscope (observation magnification: 10,000 times), and the minimum L/S of the normally patterned sample and the exposure amount at that time are shown in Table 2. The smaller the minimum L/S is, the better the resolution is, and the smaller the exposure amount is, the better the sensitivity is. Note that it was determined that a sample vertically patterned without pattern collapse was normally patterned. The pattern shape was evaluated according to the following evaluation criteria. Note that the polyhydroxyamide compound used in Comparative Example 3 did not have alkali solubility or had very low alkali solubility as shown in Table 1, and therefore did not form a pattern.

### (Evaluation criteria)

A: A substantially rectangular pattern was formed, and there was no development residue in the unexposed portion.
B: A substantially rectangular pattern was formed, but there was a development residue in the unexposed portion.
C: No substantially rectangular pattern was formed, or a pattern having an L/S width larger than desired was formed due to swelling of the pattern or the like.

### (Evaluation about PFAS regulations)

It was evaluated whether or not the polyhydroxyamide compounds A-1 to A-7 used in each of the examples and comparative examples would be subject to PFAS regulations.

### (Evaluation criteria)

PASS: The sample is not subject to PFAS regulations
FAIL: The sample may be subject to PFAS regulations

**[Table 2]**

| | | | Example | | | Comparative Example | | |
|---|---|---|---|---|---|---|---|---|
| | | | 1 | 2 | 3 | 1 | 2 | 3 |
| (A) Polyhydroxyamide | | A-1 | - | - | - | - | - | 100 |
| | | A-2 | - | - | - | - | - | - |
| | | A-3 | 100 | - | - | - | - | - |
| | | A-4 | - | 100 | - | - | - | - |
| | | A-5 | - | - | 100 | - | - | - |
| | | A-6 | - | - | - | 100 | - | - |
| | | A-7 | - | - | - | - | 100 | - |
| (B) Crosslinking agent | | MW-390 | 40 | 40 | 40 | 40 | 40 | 40 |
| (C) Photoacid generator | | PAG-103 | 5 | 5 | 5 | 5 | 5 | 5 |
| (D) Basic compound | | Triethanolamine | 0.15 | 0.15 | 0.15 | 0.15 | 0.15 | 0.15 |
| Solvent | | Cyclopentanone | 400 | 400 | 400 | 210 | 400 | 400 |
| | | DMSO | - | - | - | 90 | - | - |
| Surfactant | | BYK-310 | 0.12 | 0.12 | 0.12 | 0.12 | 0.12 | 0.12 |
| Evaluation results | PEB 120°C | Minimum L/S(*µ*m) | 9/9 | 7/7 | 10/10 | 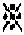 | 2/2 | - |
| | | Exposure amount at minimum L/S(mj/cm²) | 1000 | 1000 | 1000 | 600 | 130 | - |
| | | Evaluation of pattern shape | A | A | B | C | A | - |
| | PFAS regulations | | PASS | PASS | PASS | PASS | FAIL | PASS |

| | | | | | | | | |
|---|---|---|---|---|---|---|---|---|
| *Measurement was impossible due to swelling. | | | | | | | | |

### Industrial Applicability

The polyhydroxyamide compound of the present invention is capable of providing a new negative photosensitive resin composition free of a resin component that may be subject to PFAS regulations. Therefore, it is possible to obtain a negative photosensitive resin composition that can comply with the PFAS regulations and has properties equivalent to those of existing negative photosensitive resin compositions. Accordingly, the polyhydroxyamide compound of the present invention can be widely used in an insulating film in various fields such as semiconductors and electronic components.

### Cross-Reference to Related Applications

The present application claims priority based on Japanese Patent Application No. 2023-190396 filed with the Japan Patent Office on November 7, 2023, the entire disclosure of which is entirely incorporated herein by reference.

## Claims

1. A polyhydroxyamide compound comprising a structural unit represented by the following (1) and a structural unit represented by the following formula (2): 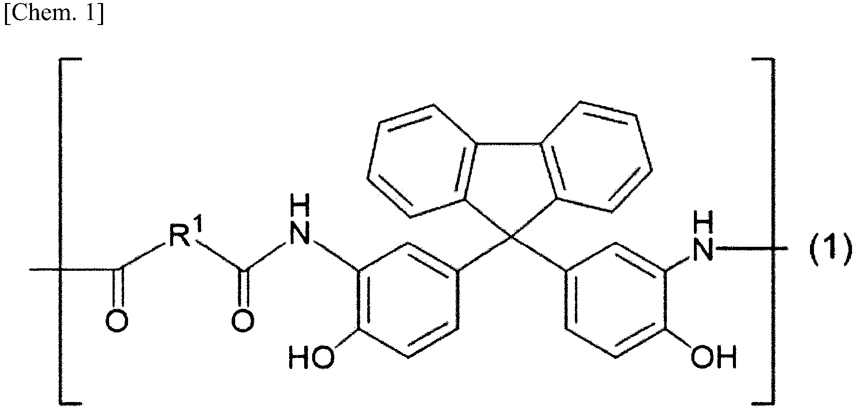
wherein R¹ is a divalent organic group; and 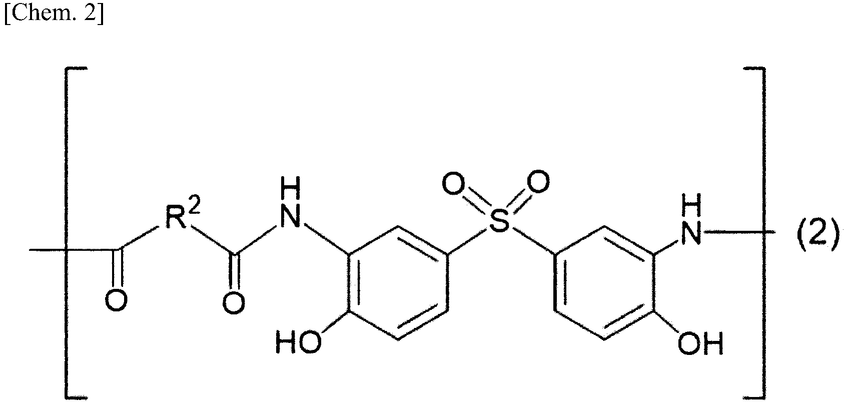
wherein R² is a divalent organic group.

2. The polyhydroxyamide compound according to claim 1, wherein a ratio [n₁/(n₁ + n₂)] of number n₁ of the structural units represented by the formula (1) to a sum of the number n₁ of structural units represented by the formula (1) and a number n₂ of structural units represented by formula (2), that is, [n₁/(n₁ + n₂)] is 0.35 to 0.80.

3. A negative photosensitive resin composition comprising the polyhydroxyamide compound according to claim 1.

4. A dry film comprising a resin layer formed of the negative photosensitive resin composition according to claim 3.

5. A cured product formed of the negative photosensitive resin composition according to claim 3 or the resin layer of the dry film according to claim 4.

6. An electronic component comprising the cured product according to claim 5.
